# FASCICULE DE BREVET EUROPEEN

(11) **EP 2 251 919 B1**
(45) Date de publication et mention de la délivrance du brevet: **20.12.2017**
(21) Numéro de dépôt: 10162459.1
(22) Date de dépôt: 10.05.2010
(51) Int. Cl.: H01L 51/05

(54) **TRANSISTOR ORGANIQUE À EFFET DE CHAMP**
ORGANISCHER FELDEFFEKTTRANSISTOR
ORGANIC FIELD-EFFECT TRANSISTOR

(30) Priorité: 14.05.2009 FR 0902338
(43) Date de publication de la demande: 17.11.2010
(73) Titulaire: Commissariat à l'Énergie Atomique et aux Énergies Alternatives, 75015 Paris (FR)
(72) Inventeur: Benwadih, Mohammed, 94500 Champigny sur Marne (FR); Bory, Cécile, 38120 Le Fontanil (FR)
(74) Mandataire: Croonenbroek, Thomas Jakob

(56) Documents cités:
- US-A1- 2009 101 986
- STADLOBER BARBARA ET AL: "High-mobility pentacene organic field-effect transistors with a high-dielectric-constant fluorinated polymer film gate dielectric", APPLIED PHYSICS LETTERS, AMERICAN INSTITUTE OF PHYSICS, US, vol. 86, no. 24, 10 juin 2005 (2005-06-10) , pages 242902-242902, XP012065884, ISSN: 0003-6951, DOI: 10.1063/1.1946190

## Description

La présente invention concerne un transistor organique à effet de champ.

Les transistors organiques à effet de champ connus à ce jour comportent :
- des électrodes de drain et de source,
- une couche semi-conductrice réalisée en matériau semi-conducteur organique disposée au moins entre lesdites électrodes de drain et de source,
- une électrode de grille, et
- une couche d'isolant électrique interposée entre l'électrode de grille et la couche semi-conductrice.

Lorsqu'un potentiel est appliqué sur l'électrode de grille, les porteurs de charges présents dans la couche semi-conductrice se concentrent à l'interface entre la couche semi-conductrice et l'isolant en restant uniquement dans la couche semi-conductrice. Cette concentration de porteurs de charges forme alors le canal de conduction caractéristique de l'état passant du transistor.

Les transistors organiques à effet de champ sont réalisés à l'aide de matériaux semi-conducteurs organiques. Ces transistors organiques à effet de champ sont également connus sous l'acronyme OFET (Organic Field Effect Transistor).

Un semi-conducteur organique est un composé organique, sous la forme d'un cristal ou d'un polymère, qui montre des propriétés similaires aux semi-conducteurs inorganiques. Ces propriétés sont la conduction par les électrons et les trous, ainsi que la présence d'une bande interdite. Ces matériaux ont donné naissance à l'électronique organique.

Notamment, la découverte du caractère conducteur des polymères en 1970 a suscité une réelle impulsion dans le vaste domaine de la microélectronique en offrant de nouvelles perspectives dans la réalisation de composants sur substrat en plastique bas coût. Ces dernières années, ce nouveau domaine de recherche communément appelé « électronique plastique » a connu un essor considérable. Des écrans à base de diodes organiques électroluminescentes (OLED) intégrées dans des appareils photos numériques, autoradios ou encore dans des rasoirs électriques ont déjà été commercialisés. Ce fantastique développement des OLEDs a alors dynamisé la recherche autour d'autres applications de l'électronique organique comme les panneaux solaires photovoltaïques à base de semi-conducteurs organiques ou les transistors organiques à effet de champ. Ces derniers permettraient la réalisation de circuits intégrés bas coût sur substrats flexibles.

On cherche cependant à améliorer les performances de conduction électrique des transistors organiques.

A cet effet, la présente invention propose un transistor organique à effet de champ selon la revendication 1. La couche piézoélectrique est ainsi configurée pour générer une onde mécanique entre les électrodes de source et de drain lorsqu'une tension V_{DS} est appliquée aux électrodes de source et de drain et qu'une tension V_{G} est appliquée à l'électrode de grille.

L'onde mécanique générée entre les électrodes de source et de drain dans la couche semi-conductrice provoque un abaissement de la barrière de potentiel entre le métal et le semi-conducteur permettant ainsi d'améliorer l'injection des charges dans le semi-conducteur et par là, d'augmenter le nombre de charges circulant dans le canal de conduction.

Selon une ou plusieurs caractéristiques du transistor organique, prise seule ou en combinaison,
- une couche d'isolation est insérée entre la couche piézoélectrique et les électrodes de source et de drain,
- l'axe longitudinal de ladite couche piézoélectrique est sensiblement parallèle à un axe défini par les électrodes de source et de drain,
- le matériau de la couche piézoélectrique présente un coefficient de couplage électromécanique supérieur à 30%,
- l'épaisseur de la couche piézoélectrique est variable au moins dans l'espace inter-électrode,
- ladite couche piézoélectrique s'étend au moins jusque sous les électrodes de source et de drain,
- ladite couche d'isolation s'étend au moins jusqu'aux dites électrodes de source et de drain,
- ladite couche semi-conductrice est de type P et ladite couche d'isolation présente une permittivité inférieure à 3,
- la couche piézoélectrique se présente sous la forme de cristaux naturels, de céramique synthétique ou de polymère,
- le transistor organique comporte un moyen d'alimentation externe de ladite couche piézoélectrique.

D'autres avantages et caractéristiques apparaîtront à la lecture de la description de l'invention, ainsi que des figures suivantes sur lesquelles :
- la figure 1 est une vue schématique en coupe verticale d'un transistor organique à effet de champ selon un premier mode de réalisation,
- la figure 2 est une vue partielle agrandie du transistor de la figure 1 en fonctionnement sur laquelle on a représenté la propagation des ondes mécaniques,
- les figures 3a, 3b et 3c sont des vues agrandies et schématiques en coupe verticale de variantes de réalisation de la couche piézoélectrique du transistor de la figure 1,
- la figure 4 est une vue analogue à la figure 1 d'un transistor organique à effet de champ selon un exemple de réalisation qui ne fait pas partie de l'invention,
- la figure 5 représente une autre réalisation d'un transistor organique qui ne fait pas partie de l'invention,
- la figure 6 représente une autre variante de réalisation d'un transistor organique qui ne fait pas partie de l'invention,
- la figure 7 représente une quatrième variante de réalisation d'un transistor organique qui ne fait pas partie de l'invention, et
- la figure 8 est un graphique illustrant l'évolution de l'intensité du courant traversant le transistor de la figure 1 en fonction de la tension V_{G} appliquée à l'électrode de grille pour un transistor comportant une couche piézoélectrique et pour un transistor classique.

Sur toutes les figures, les éléments identiques portent les mêmes numéros de référence.

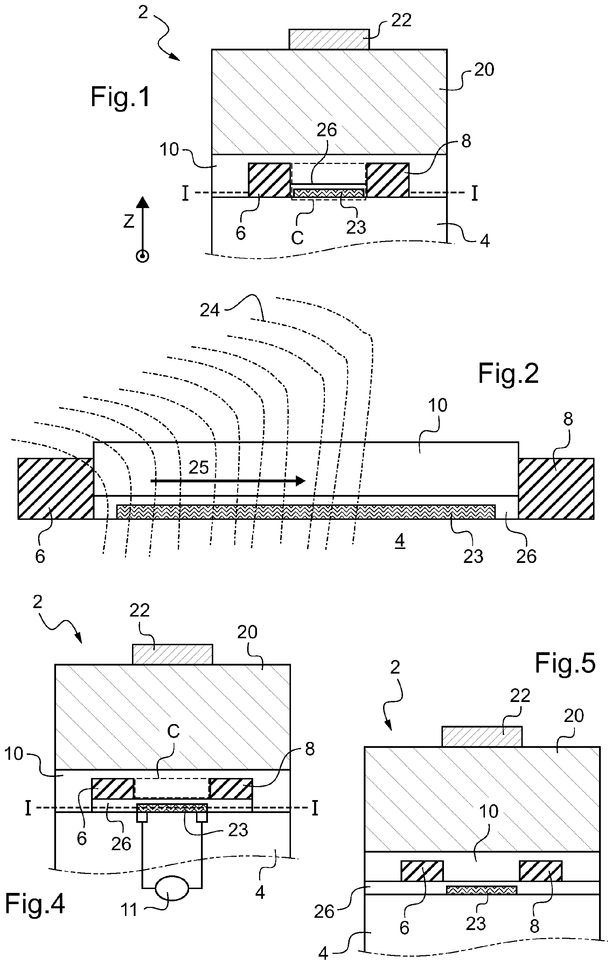

La figure 1 représente un transistor organique 2 à effet de champ réalisé selon un premier mode de réalisation. Le transistor 2 comporte un substrat 4 sur lequel sont directement réalisées une électrode de source 6 et une électrode de drain 8. Le substrat 4 présente par exemple une épaisseur de 125 µm et les électrodes de source 6 et de drain 8, présentent une épaisseur d'au moins 30 nm. Ici, les épaisseurs sont mesurées dans une direction verticale Z perpendiculaire à la face du substrat 4 sur laquelle sont déposées les différentes électrodes et couches formant le transistor 2. Les électrodes de source 6 et de drain 8 sont espacées l'une de l'autre par un espace inter-électrodes C.

Une couche semi-conductrice 10 réalisée en matériau semi-conducteur organique est déposée au moins entre les électrodes 6 et 8, par exemple par-dessus des électrodes 6 et 8. La couche semi-conductrice organique 10 peut être de type P ou de type N et peut se présenter sous forme de polymères ou de cristaux.

Cette couche semi-conductrice 10 est mécaniquement et électriquement directement en contact avec les électrodes 6 et 8 et remplit au moins l'espace inter-électrodes C séparant les électrodes 6 et 8. Par directement en contact, on désigne ici le fait que le contact s'effectue sans passer par l'intermédiaire d'une couche intermédiaire. L'épaisseur minimale de la couche semi-conductrice 10 est par exemple comprise entre 50 nm et 500 nm, tel que 100 nm.

Une couche d'isolant électrique ou une couche diélectrique 20 est interposée entre l'électrode de grille et la couche semi-conductrice 10. La face inférieure de la couche d'isolant électrique 20 est directement et mécaniquement en contact avec la face supérieure de la couche semi-conductrice 10. Cette couche d'isolant électrique 20 permet d'isoler électriquement une électrode de grille 22 de la couche semi-conductrice 10. L'épaisseur de la couche d'isolant électrique 20 est par exemple comprise entre 50 nm et 2 µm tel que 800 nm.

L'électrode de grille 22 est disposée sensiblement au-dessus de l'espace inter-électrode C séparant les électrodes 6 et 8. L'électrode de grille 22 présente une épaisseur par exemple comprise entre 100 nm et 1 µm, tel que 100 nm. Cette électrode de grille 22 est apte à créer un champ électrique qui accroît la densité des porteurs de charges électriques à l'interface entre les couches semi-conductrice 10 et d'isolant électrique 20, de manière à créer un canal de conduction dans la couche semi-conductrice 10. En effet, la couche 20 étant un isolant électrique, les porteurs de charges susceptibles de se déplacer sont uniquement situés du côté de la couche semi-conductrice 10. Le canal de conduction permet de faire circuler des charges (courant I_{ON}) entre les électrodes de source 6 et de drain 8 lorsqu'une tension V_{DS} est également appliquée entre ces électrodes. Dans cet état, le transistor 2 est dit dans l'état passant. A l'inverse, lorsque aucune tension V_{G} n'est appliquée sur l'électrode de grille 22, aucun canal de conduction n'est créé de sorte que seul un courant très faible I_{off} peut circuler entre les électrodes 6 et 8 lorsqu'une tension V_{DS} est appliquée entre celles-ci. Dans le cas illustré par les figures, la tension V_{G} appliquée sur l'électrode 22 pour faire commuter le transistor 2 de l'état non passant vers l'état passant est négative.

Le transistor 2 comporte en outre une couche piézoélectrique 23 disposée à proximité du canal de conduction (plus précisément, sous le canal de conduction dans les exemples représentés sur les figures) dans la couche semi-conductrice 10 entre les électrodes de source 6 et de drain 8 ou à l'opposé de l'électrode de grille 22 par rapport aux couches d'isolant électrique 20 et semi-conductrice 10, à côté des électrodes de source 6 et de drain 8, ladite couche piézoélectrique étant isolée électriquement desdites électrodes de source 6 et de drain 8 et de la couche semi-conductrice 10.

La couche piézoélectrique 23 est ainsi configurée pour générer une onde mécanique entre les électrodes de source 6 et de drain 8 lorsqu'une tension V_{DS} est appliquée aux électrodes de source 6 et de drain 8.

L'onde mécanique générée entre les électrodes de source 6 et de drain 8 dans la couche semi-conductrice 10 provoque un abaissement de la barrière de potentiel entre le métal et le semi-conducteur permettant ainsi d'améliorer l'injection des charges dans le semi-conducteur et par là, d'augmenter le nombre de charges circulant dans le canal de conduction.

En effet, lorsqu'une tension V_{DS} est appliquée entre les électrodes 6 et 8, un champ électrique est appliqué à la couche piézoélectrique 23. La variation de champ électrique aux bornes de la couche piézoélectrique 23 créé alors une onde mécanique.

Dans le premier mode de réalisation illustré par la figure 1, la couche piézoélectrique 23 est disposée entre les électrodes de source 6 et de drain 8, dans l'espace inter-électrodes C. La couche piézoélectrique 23 est déposée de sorte que l'axe longitudinal I-I de la couche piézoélectrique 23 soit sensiblement parallèle à un axe défini par les électrodes de source 6 et de drain 8, de manière à orienter les ondes mécaniques entre lesdites électrodes.

Ainsi, lorsqu'un champ électrique est appliqué aux bornes de la couche piézoélectrique 23, la structure cristalline de celle-ci va se rétracter ou s'allonger dans une direction privilégiée, entrainant une déformation macroscopique de la couche 23. La déformation est proportionnelle à la tension qui lui est appliquée. En fonctionnement du transistor 2, le champ électrique appliqué aux bornes de la couche piézoélectrique 23 est celui qui est déjà appliqué entre les électrodes de source 6 et de drain 8. Ainsi, on n'a pas besoin d'une autre source de tension pour alimenter la couche piézoélectrique 23, on utilise la tension V_{DS} imposée aux électrodes de source 6 et de drain 8. La différence de potentiel entre les électrodes est par exemple comprise entre +15V et -40V pour une couche semi-conductrice de type P. Pour une couche piézoélectrique de type céramique, la contrainte mécanique générée est alors proportionnelle à l'alimentation.

On peut en outre prévoir que le transistor organique 2 comporte un moyen d'alimentation externe 11 en tension directement connecté aux bornes de la couche piézoélectrique 23 (voir par exemple la figure 4). La couche piézoélectrique 23 du transistor peut alors être alimentée indépendamment du fonctionnement du transistor 2.

On peut ainsi appliquer par exemple une tension continue pulsée ou un champ alternatif, avec une fréquence et une puissance adaptées à la contrainte mécanique recherchée, qui peuvent alors être plus élevées que celles autorisées par le transistor 2. Une onde acoustique ou mécanique peut alors être créée grâce au champ alternatif permettant ainsi de mettre sous contrainte constante la couche piézoélectrique sous ce champ répété et inversé.

Un faisceau d'ondes mécaniques de compression et de torsion est alors émis et se propage dans la couche semi-conductrice 10. On a illustré la propagation des ondes mécaniques 24 partant de l'électrode de source 6 sur la figure 2 pendant la phase transitoire à l'état passant du transistor 2. Ces déformations agissent en exerçant une contrainte sur le canal de conduction permettant d'améliorer la conduction dans le canal. En outre, la propagation de l'onde générée agit en diminuant la barrière des pièges par l'accélération de la vitesse des charges lors du transport des charges dans la couche semi-conductrice 10. L'onde mécanique apporte ainsi une énergie supplémentaire aidant le transport du courant entre les électrodes de source 6 et de drain 8 au cours du changement d'état du transistor permettant ainsi de réduire son temps de réponse. En outre, la présence de cette onde au niveau de l'électrode de drain 8 améliore la capture des charges.

Pour une couche semi-conductrice de type P, le champ électrique V_{DS} entre l'électrode de source 6 et l'électrode de drain 8 est négatif, de sorte que les ondes mécaniques sont dirigées préférentiellement dans le sens et la direction de la source 6 vers le drain 8 (voir flèche 25). Les charges sont alors transportées et accélérées par les ondes mécaniques 24 vers l'électrode de drain 8. La couche piézoélectrique 23 agit alors comme un « aspirateur » de charges vers l'électrode de drain 8.

On peut prévoir que l'épaisseur de la couche piézoélectrique 23 est variable selon l'axe longitudinal I-I, au moins dans l'espace inter-électrode C, procurant une forme spécifique à la couche piézoélectrique 23 pour accentuer une direction de propagation des ondes entre les électrodes de source 6 et de drain 8.

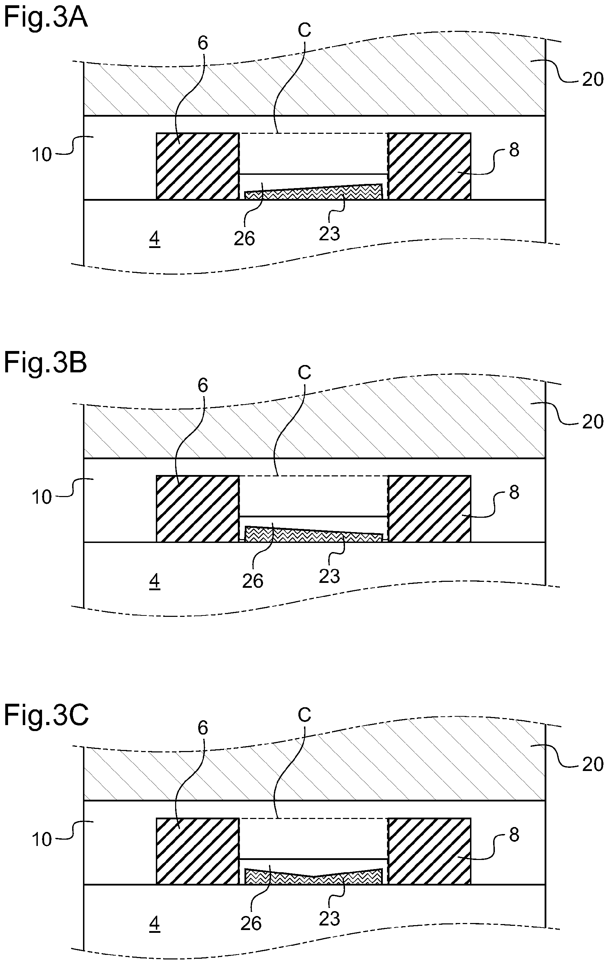

Les figures 3A, 3B et 3C illustrent des exemples de réalisation de la couche piézoélectrique 23. Dans l'exemple de la figure 3A, la couche piézoélectrique 23 présente une forme générale trapézoïdale avec une épaisseur croissante de l'électrode de source 6 vers l'électrode de drain 8. On favorise alors la capture des charges par l'électrode de drain 8. Dans l'exemple de la figure 3B, la couche piézoélectrique 23 présente également une forme générale trapézoïdale avec une épaisseur décroissante de l'électrode de source 6 vers l'électrode de drain 8. On privilégie alors le transport des charges vers l'électrode de drain 8. En outre, dans l'exemple de la figure 3C, la couche piézoélectrique 23 présente une forme générale en creux avec une épaisseur décroissante puis croissante de l'électrode de source 6 vers l'électrode de drain 8. On focalise alors la canalisation des charges vers les électrodes.

Le principe de fonctionnement pour un transistor comprenant une couche semi-conductrice de type N est similaire, le signe des polarisations V_{G}, V_{DS} et le sens privilégié de propagation de l'onde mécanique étant opposés.

La couche mince piézoélectrique 23 présente une épaisseur par exemple comprise entre 1 nanomètre et 1 micromètre selon la nature du matériau qui peut être de tout type.

Elle peut se présenter sous forme de cristaux naturels tels que le quartz, la topaze, la tourmaline, la berlinite (AlPO₄), le sucre ou le sel de Rochelle, l'orthophosphate de gallium (GaPO₄) ; les cristaux d'hydroxy-apatite, l'arséniate de gallium (GaAsO₄) ; les céramiques de structure cristalline perovskite ou de structures tungstène-bronze (PbTiO₃, BaTiO₃, KNbO₃, LiNbO₃, LiTaO₃, BiFeO₃, NaxWO₃, Ba₂NaNb₅O₅, Pb₂KNb₅O₁₅, Pb(Zr_{0.5}Ti_{0.5})O₃. Ces matériaux présentent un coefficient de couplage électromécanique k, représentant le rapport entre l'énergie mécanique obtenue et l'énergie électrique fournie, supérieur à 30%.

On peut également utiliser une couche piézoélectrique en céramique synthétique, telle que les céramiques PZT (de formule chimique Pb(ZrₓTi₁₋ₓ)O₃ ou Titano-Zirconate de Plomb). L'épaisseur de la couche piézoélectrique en céramique synthétique est par exemple comprise entre 0, 5 et 1 µm. On peut également utiliser une couche piézoélectrique en polymère tel que le polyvinylidine difluoride (PVDF) (-CH2-CF2-)n et ses dérivés, les langasites (par exemple : le composé Ba₃NbFe₃Si₂O₁₄). Les piézoélectriques de type polymère présentent l'avantage d'être faciles à mettre en forme et donc peu onéreux. Ils présentent cependant de faibles coefficients de couplage électromécanique (12 à 15% pour le PVDF et jusqu'à 30% pour le copolymère P(VDF-TrFE)).

Il peut enfin être avantageux de choisir un matériau piézoélectrique qui soit en plus pyroélectrique, tel que le phosphotellurate d'ammonium. Son échauffement lors du fonctionnement du transistor peut en améliorer les performances.

Pour isoler électriquement la couche piézoélectrique 23 de la couche semi-conductrice 10 et des électrodes de sources 6 et de drain 8, on prévoit par exemple selon la forme de la couche piézoélectrique, une couche d'isolation 26 insérée entre la couche piézoélectrique 23 et les électrodes de source 6 et de drain 8. La couche d'isolation 26 permet d'éviter un court-circuit entre les électrodes de source 6 et de drain 8 et la couche piézo-électrique 23.

Dans le cas où la couche piézoélectrique 23 ne touche pas les électrodes de source 6 et de drain 8 et dans le cas d'un semi-conducteur de type N, cette couche d'isolation n'est pas nécessaire. En revanche, pour un semi-conducteur de type P, cette couche d'isolation 26 devient très utile pour que la couche piézoélectrique 23 ne perturbe pas le semi-conducteur. On choisit alors avantageusement une couche d'isolation dont la permittivité est inférieure à 3.

De manière à améliorer les performances du transistor 2, la couche d'isolation 26 est agencée pour que son épaisseur dans la direction verticale Z soit aussi fine que possible, et ainsi ne pas faire de barrière à l'onde mécanique tout en présentant une bonne isolation sans présenter une capacité trop importante. L'épaisseur de la couche d'isolation 26 dépend du matériau utilisé pour la couche piézoélectrique 23. On choisit cependant une fine couche d'épaisseur par exemple comprise entre 10 et 500 nanomètres. Une épaisseur inférieure à 150 nm permet de rendre négligeable la limitation ou l'atténuation de la propagation de l'onde mécanique.

Selon les exemples représentés sur les figures 4 à 7, la couche piézoélectrique 23 est disposée sur le substrat 4 du transistor 2 et sous les électrodes de source 6 et de drain 8. L'axe longitudinal I-I de la couche piézoélectrique 23 est sensiblement parallèle à un axe défini par les électrodes de source 6 et de drain 8.

Selon une première variante, la couche piézoélectrique 23 est disposée sous l'espace inter-électrodes C (figure 4). En outre, la couche d'isolation 26 s'étend sous les électrodes de source 6 et de drain 8.

Selon une deuxième variante, la couche piézoélectrique 23 est disposée sous l'espace inter-électrodes C et la couche d'isolation 26 s'étend au-delà des électrodes de source 6 et de drain 8 (voir la figure 5).

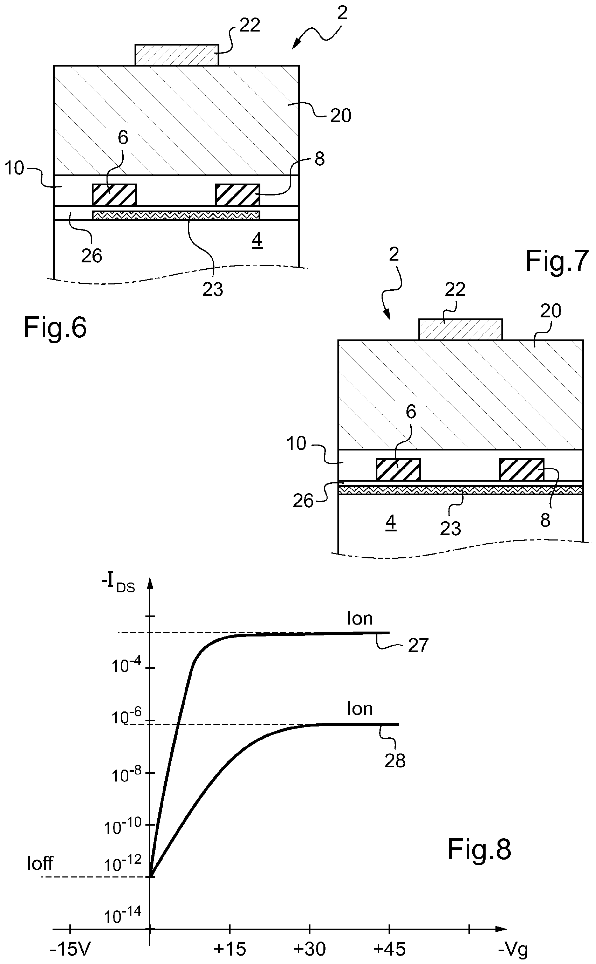

Selon une troisième variante, la couche piézoélectrique 23 est disposée sur le substrat 4 du transistor 2 et s'étend de part et d'autre sous les électrodes de source 6 et de drain 8 (figure 6).

Selon une quatrième variante, la couche piézoélectrique 23 est disposée sur le substrat 4 et s'étend au-delà des électrodes de source 6 et de drain 8 (figure 7).

On préfère cependant les modes de réalisation pour lesquels la couche piézoélectrique 23 est confinée dans ou sous l'espace inter-électrodes C (figures 1, 4 et 5) car on limite ainsi la formation de capacités ou de polarisations parasites entre les électrodes de source 6 et de drain 8 et la couche piézoélectrique 23.

Toutes ces réalisations correspondent à une architecture de transistor dite « à grille haute ». La présente invention s'applique également à d'autres architectures par exemple, celle dite « à grille basse » ou celle dite « verticale » (seul le substrat change d'emplacement).

Pour constater l'amélioration du rapport Iₒₙ/I_{off} du transistor 2 par rapport à un transistor ne comportant pas de couche piézoélectrique, on a représenté en figure 8, un graphique de l'évolution de l'intensité du courant I_{DS} circulant entre les électrodes de drain 8 et de source 6, en fonction de la tension V_{G} appliquée à l'électrode de grille 22 pour un transistor 2 de type P comprenant une couche piézoélectrique 23 (courbe 27) et pour un transistor de type P ne comprenant pas de couche piézoélectrique (courbe 28).

Pour les deux courbes 27, 28, lorsque la tension V_{G} est positive, l'intensité du courant -I_{DS} est égale à l'intensité du courant I_{off}. Puis, lorsque la tension -V_{G} est comprise entre 0 et environ 10V, l'intensité du courant -I_{DS} augmente proportionnellement à la tension -V_{G} (régime linéaire). Au-delà, pour les deux courbes 27, 28, dans un régime stationnaire, l'intensité du courant I_{DS} sature.

On constate ainsi que pour une faible tension V_{DS}, l'action de la couche piézoélectrique 23 est également faible de sorte que son intégration dans le transistor 2 ne modifie pas le fonctionnement du transistor 2 à l'état non passant. Seul le même courant très faible I_{off} peut circuler entre les électrodes 6 et 8.

En revanche, pour une tension V_{DS} importante, l'intensité du courant -I_{DS} d'un transistor organique 2 comprenant une couche piézoélectrique 23, en régime linéaire ou stationnaire, est supérieure de plusieurs décades à l'intensité du courant -I_{DS} d'un transistor organique classique. L'action de la couche piézoélectrique 23 devient alors importante, et permet d'augmenter la pente de l'intensité du courant en fonction de la tension de grille V_{G}, ce qui permet d'augmenter l'intensité du courant I_{ON}.

On comprend donc qu'un tel transistor 2 comportant une couche piézoélectrique 23 à proximité du le canal de conduction permet d'améliorer nettement l'injection et le transport de charges dans le canal de conduction.

## Revendications

1. Transistor organique à effet de champ comprenant :
- des électrodes de source (6) et de drain (8),
- une couche semi-conductrice (10) réalisée en matériau semi-conducteur organique disposée au moins entre lesdites électrodes de source (6) et de drain (8),
- une électrode de grille (22) propre à créer un champ électrique qui accroît la densité des porteurs mobiles de charges dans la couche semi-conductrice (10) pour créer un canal de conduction dans cette couche semi-conductrice (10) entre les électrodes de source (6) et de drain (8) lorsqu'une tension V_{G} est appliquée sur l'électrode de grille (22), et
- une couche d'isolant électrique (20) interposée entre l'électrode de grille (22) et la couche semi-conductrice (10),
- une couche piézoélectrique (23) disposée à proximité du canal de conduction, **caractérisé en ce que** la couche piézoélectrique est disposée dans la couche semi-conductrice (10) entre les électrodes de source (6) et de drain (8), dans l'espace inter-électrodes (C), ladite couche piézoélectrique étant isolée électriquement desdites électrodes de source (6) et de drain (8) et de la couche semi-conductrice (10).

2. Transistor organique selon la revendication 1, **caractérisé en ce qu'**une couche d'isolation (26) est insérée entre la couche piézoélectrique (23) et les électrodes de source (6) et de drain (8).

3. Transistor organique selon l'une des revendications 1 ou 2, **caractérisé en ce que** l'axe longitudinal (T-I) de ladite couche piézoélectrique (23) est sensiblement parallèle à un axe défini par les électrodes de source (6) et de drain (8).

4. Transistor organique selon l'une des revendications précédentes, **caractérisé en ce que** le matériau de la couche piézoélectrique (23) présente un coefficient de couplage électromécanique supérieur à 30%.

5. Transistor organique selon l'une des revendications précédentes, **caractérisé en ce que** l'épaisseur de la couche piézoélectrique (23) est variable au moins dans l'espace inter-électrode (C).

6. Transistor organique selon l'une des revendications 2 à 5, **caractérisé en ce que** ladite couche semi-conductrice (10) est de type P et **en ce que** ladite couche d'isolation (26) présente une permittivité inférieure à 3.

7. Transistor organique selon l'une des revendications précédentes, **caractérisé en ce que** la couche piézoélectrique (23) se présente sous la forme de cristaux naturels, de céramique synthétique ou de polymère.

8. Transistor organique selon l'une des revendications précédentes, **caractérisé en ce qu'**il comporte un moyen d'alimentation externe (11) de ladite couche piézoélectrique (23).

## Patentansprüche

1. Organischer Feldeffekttransistor, umfassend:
- Source- (6) und Drain- (8) Elektroden,
- eine Halbleiterschicht (10), die aus einem organischen Halbleitermaterial gebildet ist, die zumindest zwischen den Source- (6) und Drain- (8) Elektroden angeordnet ist,
- eine Gate-Elektrode (22), die geeignet ist, ein elektrisches Feld zu erzeugen, das die Dichte der beweglichen Ladungsträger in der Halbleiterschicht (10) erhöht, um einen Leitkanal in dieser Halbleiterschicht (10) zwischen den Source- (6) und Drain- (8) Elektroden zu erzeugen, wenn eine Spannung V_{G} an die Gate-Elektrode (22) angelegt wird, und
- eine Schicht aus einem elektrischen Isolator (20), die zwischen der Gate-Elektrode (22) und der Halbleiterschicht (10) angeordnet ist,
- eine piezoelektrische Schicht (23), die in der Nähe des Leitkanals angeordnet ist, **dadurch gekennzeichnet, dass** die piezoelektrische Schicht in der Halbleiterschicht (10) zwischen den Source- (6) und Drain- (8) Elektroden in dem Elektrodenzwischenraum (C) angeordnet ist, wobei die piezoelektrische Schicht elektrisch von den Source- (6) und Drain- (8) Elektroden der Halbleiterschicht (10) isoliert ist.

2. Organischer Transistor nach Anspruch 1, **dadurch gekennzeichnet, dass** eine Isolierschicht (26) zwischen der piezoelektrischen Schicht (23) und den Source-(6) und Drain- (8) Elektroden eingefügt ist.

3. Organischer Transistor nach einem der Ansprüche 1 oder 2, **dadurch gekennzeichnet, dass** die Längsachse (I-I) der piezoelektrischen Schicht (23) im Wesentlichen parallel zu einer Achse ist, die von den Source- (6) und Drain- (8) Elektroden definiert ist.

4. Organischer Transistor nach einem der vorhergehenden Ansprüche, **dadurch gekennzeichnet, dass** das Material der piezoelektrischen Schicht (23) einen elektromechanischen Kopplungskoeffizienten aufweist, der größer als 30% ist.

5. Organischer Transistor nach einem der vorhergehenden Ansprüche, **dadurch gekennzeichnet, dass** die Dicke der piezoelektrischen Schicht (23) zumindest in dem Elektrodenzwischenraum (C) variabel ist.

6. Organischer Transistor nach einem der Ansprüche 2 bis 5, **dadurch gekennzeichnet, dass** die Halbleiterschicht (10) vom P-Typ ist und dadurch, dass die Isolierschicht (26) eine Permittivität aufweist, die kleiner als 3 ist.

7. Organischer Transistor nach einem der vorhergehenden Ansprüche, **dadurch gekennzeichnet, dass** die piezoelektrische Schicht (23) in Form von natürlichen Kristallen, von synthetischer Keramik oder in Polymerform vorliegt.

8. Organischer Transistor nach einem der vorhergehenden Ansprüche, **dadurch gekennzeichnet, dass** er Mittel zur externen Versorgung (11) der piezoelektrischen Schicht (23) umfasst.

## Claims

1. Organic field-effect transistor comprising:
- source (6) and drain (8) electrodes;
- a semiconductor layer (10) made of an organic semiconductor material placed at least between said source (6) and drain (8) electrodes;
- a gate electrode (22) suitable for creating an electric field that increases the density of mobile charge carriers in the semiconductor layer (10) in order to create a conduction channel in this semiconductor layer (10) between the source (6) and drain (8) electrodes when a voltage V_{G} is applied to the gate electrode (22); and
- an electrical insulator layer (20) interposed between the gate electrode (22) and the semiconductor layer (10),
- a piezoelectric layer (23) placed close to the conduction channel,
**characterized in that** the piezoelectric layer is placed in the semiconductor layer (10) between the source (6) and drain (8) electrodes, in the inter-electrode space (C), said piezoelectric layer being electrically isolated from said source (6) and drain (8) electrodes and from the semiconductor layer (10).

2. Organic transistor according to Claim 1, **characterized in that** an insulation layer (26) is inserted between the piezoelectric layer (23) and the source (6) and drain (8) electrodes.

3. Organic transistor according to either of Claims 1 and 2, **characterized in that** the longitudinal axis (I-I) of said piezoelectric layer (23) is approximately parallel to an axis defined by the source (6) and drain (8) electrodes.

4. Organic transistor according to one of the preceding claims, **characterized in that** the material of the piezoelectric layer (23) has an electromechanical coupling coefficient greater than 30%.

5. Organic transistor according to one of the preceding claims, **characterized in that** the thickness of the piezoelectric layer (23) is variable, at least in the inter-electrode space (C).

6. Organic transistor according to one of Claims 2 to 5, **characterized in that** said semiconductor layer (10) is of the p-type and **in that** said insulation layer (26) has a permittivity of less than 3.

7. Organic transistor according to one of the preceding claims, **characterized in that** the piezoelectric layer (23) is in natural-crystal, synthetic-ceramic or polymeric form.

8. Organic transistor according to one of the preceding claims, **characterized in that** it includes an external power supply means (11) for said piezoelectric layer (23).
